(19) Europäisches Patentamt
European Patent Office
Office européen des brevets

(11) **EP 3 874 283 B1**

(12) **EUROPÄISCHE PATENTSCHRIFT**

(45) Veröffentlichungstag und Bekanntmachung des Hinweises auf die Patenterteilung:
**20.03.2024   Patentblatt 2024/12**

(21) Anmeldenummer: **19804643.5**

(22) Anmeldetag: **01.11.2019**

(51) Internationale Patentklassifikation (IPC):
***G01R 27/26*** *(2006.01)*      ***G01R 15/06*** *(2006.01)*

(52) Gemeinsame Patentklassifikation (CPC):
**G01R 27/2611; G01R 15/06**

(86) Internationale Anmeldenummer:
**PCT/EP2019/079987**

(87) Internationale Veröffentlichungsnummer:
**WO 2020/089462 (07.05.2020 Gazette 2020/19)**

(54) **VERFAHREN UND MESSVORRICHTUNG ZUR ERMITTLUNG DER INDUKTIVITÄT EINES ELEKTRISCHEN BAUELEMENTS**

METHOD AND MEASURING DEVICE FOR DETERMINING THE INDUCTANCE OF AN ELECTRICAL COMPONENT

PROCÉDÉ ET DISPOSITIF DE MESURE POUR DÉTERMINER L'INDUCTANCE D'UN COMPOSANT ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.11.2018   DE 102018127378**

(43) Veröffentlichungstag der Anmeldung:
**08.09.2021   Patentblatt 2021/36**

(73) Patentinhaber: **BS & T Frankfurt am Main GmbH 60438 Frankfurt am Main (DE)**

(72) Erfinder:
• **SUN, Jun-Chao**
**60438 Frankfurt am Main (DE)**
• **TESKE, Christian**
**Chineham, Basingstroke RG24 8RL (GB)**

(74) Vertreter: **Habermann Intellectual Property Partnerschaft von Patentanwälten mbB Dolivostraße 15A 64293 Darmstadt (DE)**

(56) Entgegenhaltungen:
**DE-A1- 2 944 472     US-A- 6 150 772**

EP 3 874 283 B1

**Beschreibung**

Die Erfindung betrifft ein Verfahren zur Ermittlung der Induktivität eines elektrischen Bauelements. Die Erfindung betrifft auch eine Messvorrichtung zur Ermittlung der Induktivität eines elektrischen Bauelements, mit welcher das erfindungsgemäße Verfahren durchgeführt werden kann.

Die elektrischen Eigenschaften eines elektrischen Bauelements, das in einer mit elektrischer Energie versorgten Vorrichtung eingesetzt werden kann, sind von ausschlaggebender Bedeutung für das betreffende elektrische Bauelement. Dies gilt in gleicher Weise auch für elektronische Bauelemente und elektronische Schaltungen, die nachfolgend nicht gesondert erwähnt und aufgeführt werden, sondern vereinfachend und zusammenfassend als elektrische Schaltungen und elektrische Bauelemente bezeichnet werden.

Die Verwendung von weichmagnetischen Materialien gewinnt dabei zunehmend an Bedeutung für die Herstellung und Auslegung kompakter und verlustarmer elektrischer Bauelemente und insbesondere bei elektrischen Bauelementen im Bereich der Leistungselektronik, die für die Umformung elektrischer Energie in Bezug auf die Spannungsform, die Höhe von Spannung und Strom sowie auf die Frequenz verwendet werden können. Dabei sind in vielen Fällen das Sättigungsverhalten sowie ein während des Betriebs auftretender Leistungsverlust eines weichmagnetischen Materials wichtige Eigenschaften eines aus oder mit einem solchen weichmagnetischen Material hergestellten induktiven elektrischen Bauelements. Die induktiven Eigenschaften solcher weichmagnetischer Materialien, bzw. ganz allgemein von magnetischen Materialien werden deshalb mit verschiedenen Messverfahren und Messvorrichtungen erfasst, um möglichst geeignete Materialien für den jeweiligen Verwendungszweck eines elektrischen Bauelements identifizieren zu können.

Eine messtechnische Herausforderung bei der Erfassung der induktiven Eigenschaften von magnetischen Materialien und insbesondere von weichmagnetischen Materialien sind dabei die oftmals hohe Feldstärken von einigen 100 kA/m und ein entsprechend großer Stromfluss, die in vielen Fällen benötigt werden, um das nicht lineare Verhalten und insbesondere das Sättigungsverhalten von weichmagnetischen Materialien erfassen zu können. Das elektrische Bauelement muss während des Messvorgangs von einem großen Messstrom von mehreren tausend Ampere, bzw. von mehreren kA durchflossen werden, um die induktiven Eigenschaften erfassen zu können, wodurch jedoch oftmals gleichzeitig ein ganz erheblicher Anteil der elektrischen Energie in Wärmeenergie umgewandelt wird und dadurch die Temperatur des elektrischen Bauelements während des Messvorgangs erhöht wird. Dies führt regelmäßig zu einer Veränderung der elektrischen Eigenschaften und zu einem Fehler bei der Bestimmung der elektrischen Eigenschaften, insbesondere der Induktivität von weichmagnetischen Materialien und daraus hergestellten elektrischen Bauelemente.

Dabei muss beachtet werden, dass bei elektrischen Bauelementen mit weichmagnetischen Materialien deren induktive Eigenschaften oftmals kein lineares Verhalten aufweisen, sondern beispielsweise ein nichtlineares Sättigungsverhalten bei hohen Stromstärken und eine Abhängigkeit der bei einem Betrieb auftretenden Energieverluste von einer zeitlichen Veränderung des jeweiligen Stromflusses.

Aus der Praxis sind verschiedene Verfahren bekannt, mit welchen die Induktivität eines elektrischen Bauelements ermittelt werden kann. Dabei eignen sich insbesondere Pulsverfahren, bei denen ein pulsförmiger Stromfluss durch das elektrische Bauelement erzeugt wird und die relevanten elektrischen Eigenschaften des üblicherweise in einem Schwingkreis angeordneten elektrischen Bauelements erfasst werden. Durch einen großen pulsförmigen Stromfluss, der kurzzeitig erzeugt wird, wird eine anschließend gedämpft ausklingende elektrische Schwingung in dem elektrischen Schwingkreis angeregt, die für die Durchführung der erforderlichen Messungen verwendet werden kann. Aufgrund der nicht kontinuierlichen, sondern nur kurzzeitigen Belastung durch den pulsförmigen Stromfluss erfolgt nur eine geringe Erwärmung bei der Messung von elektrischen Bauelementen mit weichmagnetischen Materialien, sodass die Messergebnisse nicht oder zumindest kaum durch eine Temperaturveränderung während der Messung beeinflusst werden.

Bei einer geeigneten Messvorrichtung für derartige Pulsverfahren ist das elektrische Bauelement in einem Schwingkreis angeordnet, wobei die Messvorrichtung eine mit dem Schwingkreis verbindbare Stromquelle aufweist, mit welcher ein Hochstromimpuls in dem Schwingkreis erzeugt werden kann und wobei mit einer Spannungsmessvorrichtung ein Spannungsabfall U über das elektrische Bauelement messbar ist. Bei der Durchführung des Messverfahrens werden nach der Anregung des Hochstromimpulses in einem Messschritt über eine Messdauer hinweg elektrische Eigenschaften des elektrischen Bauelements gemessen, wobei in einem Auswerteschritt aus den gemessenen elektrischen Eigenschaften die Induktivität L des elektrischen Bauelements ermittelt werden kann.

Die Induktivität L beschreibt den Zusammenhang einer sich zeitlich verändernden Änderungsrate des elektrischen Stroms $dI(t)/dt$ in Bezug auf die durch die Veränderung des elektrischen Stroms $I(t)$ induzierte elektrische Spannung $U(t)$. Für den Fall einer sich zeitlich nicht verändernden Induktivität kann die Induktivität als Proportionalitätskonstante L angegeben werden. Die durch eine Veränderung des elektrischen Stroms $I(t)$ induzierte Spannung $U(t)$ kann als Produkt der Induktivität L mit der Änderungsrate der Stromstärke $d_I(t)/dt$ beschrieben werden:

$$U(t) = L\,\frac{dI(t)}{dt}$$

Bei den aus der Praxis bekannten Messverfahren werden deshalb zur Ermittlung der Induktivität L sowohl ein Spannungsabfall U(t) über das elektrische Bauelement als auch ein Stromfluss I(t) durch das elektrische Bauelement gemessen und aus dem gemessenen Werten für den Spannungsabfall U(t) und der zeitlichen Veränderung des Stromflusses dI(t)/dt die Induktivität berechnet, wobei die Veränderungrate des Stromflusses dI(t)/dt nicht direkt gemessenen, sondern aus dem gemessenen Stromfluss I(t) ermittelt wird. Die Berechnung der Induktivität L aus dem gemessenen Spannungsabfall U(t) und dem jeweiligen Stromfluss I(t) durch das elektrische Bauelement ist jedoch mit einer vergleichsweise großen messtechnischen Unsicherheit behaftet.

Aus DE 29 44 472 A1 ist eine vorangehend beschriebene Messvorrichtung bekannt, mit welcher ein derartiges Verfahren durchgeführt werden kann.

Es wird deshalb als eine Aufgabe der vorliegenden Erfindung angesehen, ein vorangehend beschriebenes Messverfahren so zu verändern und weiterzuentwickeln, dass mit möglichst einfachen Mitteln eine möglichst genaue Ermittlung der elektrischen Eigenschaften und insbesondere der Induktivität eines elektrischen Bauelements ermöglicht wird, wobei die Erfindung durch das Verfahren des Anspruchs 1 und die Messvorrichtung des Anspruchs 7 definiert wird.

Diese Aufgabe wird erfindungsgemäß dadurch gelöst, dass in dem Auswerteschritt die Induktivität L des elektrischen Bauelements als Produkt der Referenzinduktivität $L_R$ mit einem Proportionalitätsfaktor berechnet wird, der von dem gemessenen Spannungsabfall U und dem gemessenen Referenzspannungsabfall $U_R$ anhängt. Die Messung eines Spannungsabfalls kann üblicherweise mit einem wesentlich geringeren messtechnischen Aufwand wesentlich präziser durchgeführt werden als die Bestimmung einer Veränderungsrate des Stromflusses, die über die Messung eines sich zeitlich verändernden Stromflusses über die Messdauer hinweg und eine anschließende Abschätzung einer sich ebenfalls zeitlich verändernden Änderungsrate des Stromflusses ermittelt wird. Bei anderen Messverfahren ist eine Integration des gemessenen Stromflusses I(t) über die Messdauer hinweg erforderlich, wodurch ebenfalls erhebliche Unsicherheiten und systematische Fehler erzeugt oder zumindest begünstigt werden.

Es hat sich gezeigt, dass durch die Verwendung eines Referenzbauelements die gleichzeitige Messung des Spannungsabfalls über das elektrische Bauelement sowie über das Referenzbauelement eine besonders präzise Bestimmung der Induktivität des elektrischen Bauelements ermöglicht wird. Der Schwingkreis, in welchem das elektrische Bauelement und das Referenzbauelement angeordnet sind, wird dabei zweckmäßigerweise so ausgelegt, dass durch den Hochstromimpuls eine gedämpfte Schwingung angeregt wird und die beiden Spannungsabfälle über mindestens einige Schwingungsamplituden hinweg zeitlich aufgelöst erfasst werden. Die Dämpfung des Schwingkreises ist dabei in vorteilhafter Weise ausreichend groß, sodass die elektrischen Schwingungen in dem Schwingkreis rasch abklingen und eine thermische Belastung des elektrischen Bauelements möglichst gering ist.

Der Hochstromimpuls kann in vorteilhafter Weise eine Stromstärke von mehreren kA aufweisen und an die magnetischen Eigenschaften des elektrischen Bauelements angepasst sein, dessen Induktivität ermittelt werden soll. Insbesondere bei elektrischen Bauelementen mit weichmagnetischen Materialien kann es vorteilhaft sein, einen Hochstromimpuls mit einer Stromstärke von mehreren kA zu verwenden, um das Sättigungsverhalten der weichmagnetischen Materialien und ein üblicherweise nicht lineares Verhalten der weichmagnetischen Materialien ermitteln zu können.

Um die Messgenauigkeit zu verbessern kann optional vorgesehen sein, zusätzlich auch während des Messschritts einen Stromfluss I(t) durch das elektrische Bauelement zu messen. Der gemessene Stromfluss kann zur Kontrolle der Messwerte für die Spannungsabfälle bei dem elektrischen Bauelement und bei dem Referenzbauelement verwendet werden. Es ist ebenfalls möglich, mit dem gemessenen Stromfluss weitere elektrische Eigenschaften des Schwingkreises zu erfassen und bei der Ermittlung der Induktivität L des elektrischen Bauelements zu berücksichtigen.

Gemäß einer besonders vorteilhaften Ausgestaltung des Erfindungsgedankens ist zu diesem Zweck vorgesehen, dass in dem Auswerteschritt der Proportionalitätsfaktor als Quotient von einerseits der Differenz zwischen dem gemessenen Spannungsabfall U und dem Produkt des ohmschen Widerstands R des elektrischen Bauelements und dem gemessenen Stromfluss I und andererseits des gemessenen Referenzspannungsabfalls $U_R$ berechnet wird. Dieser Zusammenhang kann wie folgt angegeben werden:

$$L = L_R\,\frac{(\,U(t) - RI(t))}{U_R(t)}$$

Insbesondere für den Fall, dass sich der elektrische Widerstand R des elektrischen Bauelements merklich auf dessen elektrischen Eigenschaften bei einer bestimmungsgemäßen Verwendung des elektrischen Bauelements auswirkt ist es vorteilhaft, den ohmschen Widerstand R bei der Ermittlung der Induktivität L des elektrischen Bauelements zu berücksichtigen.

Der ohmsche Widerstand R kann einer Ausgestaltung des Erfindungsgedankens zu Folge vergleichsweise präzise als Mittelwert der Quotienten aus dem Spannungsabfall U und dem Stromfluss $I_{peak}$ an mehreren Amplitudenmaxima des Stromflusses I durch das elektrische Bauelement während der Messdauer ermittelt werden, wobei die Messdauer einige Amplitudenmaxima der gedämpften Schwingung des elektrischen Schwingkreises umfasst:

$$R = \frac{U\left(I_{peak}\right)}{I_{peak}}$$

Die Amplitudenmaxima $I_{peak}$ des Stromflusses I stellen Extrempunkte dar, in denen kurzzeitig der Einfluss der Induktivität L auf den Stromfluss durch das elektrische Bauelement vernachlässigt werden kann und der ohmsche Widerstand R des elektrischen Bauelements sich in guter Näherung aus dem Quotienten aus dem gemessenen Spannungsabfall U dem gemessenen Stromfluss I ergibt. Durch die Bildung eines Mittelwerts für den derart berechneten ohmschen Widerstand R über mehrere Amplitudenmaxima, bzw. Extrempunkte des Stromflusses hinweg kann die Genauigkeit bei der Ermittlung des ohmschen Widerstands R verbessert werden.

Die Induktivität L des elektrischen Bauelements kann dann als Produkt der bekannten Induktivität $L_R$ mit dem Quotienten aus der Differenz U - RI einerseits und dem Spannungsabfall $U_R$ andererseits berechnet werden, wie es in der nachstehend beschriebenen Formel zusammengefasst ist, wobei die Induktivität L in Abhängigkeit von dem mit dem Hochstromimpuls $I_{puls}$ angeregten Stromfluss I(t) ermittelt wird:

$$L\left(I_{puls}\right) = L_R \frac{\left(U(t) - R\,I(t)\right)}{U_R(t)}$$

Dabei entspricht die Differenz U - RI der elektromotorischen Kraft. Falls die Induktivität L eine lineare Abhängigkeit von dem Stromfluss und demzufolge kein Sättigungsverhalten aufweisen würde, wäre die Induktivität L für verschiedene Hochstromimpulse gleich. Aufgrund des insbesondere bei weichmagnetischen Materialien ausgeprägten Sättigungsverhaltens bei hohen Stromflüssen zeigt die Induktivität L eine Abhängigkeit von dem Stromfluss, bzw. von dem vorgegebenen Hochstromimpuls, die durch Messungen mit unterschiedlich hoch vorgegebenen Hochstromimpulsen erfasst und ausgewertet werden kann.

Ausgehend von den über die Messdauer hinweg gemessenen Werten für die Spannungsabfälle U und $U_R$ sowie für den Stromfluss I können zusätzlich weitere charakteristische elektrische Eigenschaften des elektrischen Bauelements ermittelt werden. Beispielsweise kann die Einfügedämpfung $a_I$ für einen vorgegebenen Hochstromimpuls $I_{puls}$ aus dem Logarithmus eines Quotienten zweier gemessener Extremwerte $U_1$ und $U_2$ von aufeinander folgenden Amplitudenmaxima $U_1$ und $U_2$ des gemessenen Spannungsabfalls bestimmt werden, wobei der Extremwert $U_1$ der betragsmäßig größere Wert eines zeitlich früheren Amplitudenmaximum des gedämpften Schwingungsverlaufs des gemessenen Spannungsabfalls U(t) ist:

$$a_I(I_{puls}) = 20 \, \log \left| \frac{U_1}{U_2} \right|$$

Für die Ermittlung der Extremwerte, bzw. der Amplitudenmaxima des Spannungsverlaufs U(t) kann bei einer automatisierten Durchführung des Ermittlungsverfahrens derselbe Algorithmus verwendet werden wie bei der Ermittlung der Amplitudenmaxima des zeitlichen Verlaufs des Stromflusses I(t) für die Bestimmung des ohmschen Widerstands R. Es ist ebenfalls denkbar, dass die Extremwerte $U_1$ und $U_2$ ebenso wie die Amplitudenmaxima des sich zeitlich ändernden Stromflusses I(t) manuell ermittelt, bzw. festgelegt werden.

So kann beispielsweise durch das Auswerten der Messwerte über eine Halbwelle der Spannungs- und Stromverläufe während einer gedämpft abklingenden Schwingung auch ein von dem Stromfluss abhängiger Energieverlust EL ermittelt werden, der für den Betrieb eines elektrischen Bauteils mit weichmagnetischen Materialien in einer Leistungselektronik von besonderer Bedeutung ist. Dabei ergibt sich der Energieverlust EL aus dem über eine Halbwelle zwischen zwei aufeinanderfolgenden Amplitudenmaxima $U_1$ und $U_2$ des Spannungsabfalls über dem elektrischen Bauteil integrierten Produkt des Spannungs- und Stromverlaufs gemäß der folgenden Formel:

$$EL = \int_{t(U_1)}^{t(U_2)} \left(U(t) * I(t)\right) \, dt$$

Um einen unerwünschten Einfluss des Anregungsschrittes, bzw. bei der Auslösung des Hochstromimpulses auf den Schwingkreis möglichst gering zu halten ist optional vorgesehen, dass der Hochstromimpuls während des Anregungsschrittes mit einer Steuereinrichtung ausgelöst wird, die galvanisch von dem Stromkreislauf mit dem elektrischen Bauelement getrennt ist. Die Steuersignale der Steuereinrichtung können beispielsweise mit einer geeigneten Faseroptik, bzw. über Lichtleiter übermittelt werden, die zwischen geeigneten Optokopplern angeordnet sind.

Bei einer erfindungsgemäßen Messvorrichtung zur Ermittlung der Induktivität des elektrischen Bauelements ist das elektrische Bauelement in einem Schwingkreis angeordnet. Die Messvorrichtung weist eine mit dem Schwingkreis verbundene Stromquelle auf, mit welcher ein Hochstromimpuls in dem Schwingkreis erzeugt werden kann. Mit einer geeigneten Spannungsmessvorrichtung kann ein Spannungsabfall U über das elektrische Bauelement gemessen werden. Die Messvorrichtung ist dazu eingerichtet, die Induktivität L des elektrischen Bauelements als Produkt der Referenzinduktivität

$L_R$ mit einem Proportionalitätsfaktor zu berechnen, der von dem gemessenen Spannungsabfall U und dem gemessenen Referenzspannungsabfall $U_R$ anhängt Während bei den aus der Praxis bekannten Messvorrichtungen regelmäßig nur eine Strommesseinrichtung vorgesehen ist und die Induktivität L aus dem gemessenen Spannungsabfall U(t) und dem gemessenen Stromfluss I(t) durch das elektrische Bauelement ermittelt bzw. abgeleitet wird, weist die erfindungsgemäße Messvorrichtung ein Referenzbauelement mit einer Referenzinduktivität $L_R$ auf, das in Reihe mit dem elektrischen Bauelement in dem Schwingkreis angeordnet ist, wobei mit einer Referenzspannungsmessvorrichtung ein Referenzspannungsabfall $U_R$ über das Referenzbauelement messbar ist. Die gleichzeitige Messung von den beiden Spannungsabfällen U über dem elektronischen Bauelement und $U_R$ über dem Referenzbauelement lässt sich mit einfachen Mitteln sehr präzise durchführen. In vielen Fällen kann beispielsweise ein Digitaloszilloskop verwendet werden, das über mehrere Messkanäle verfügt.

Das Referenzbauelement kann in vorteilhafterweise die Funktion einer Sicherungsinduktivität übernehmen, die in dem Schwingkreis angeordnet ist und so dimensioniert ist, dass bei dem Hochstromimpuls sowohl die maximal auftretende Spitzenamplitude des Hochstromimpulses als auch eine Stromanstiegsrate in dem Schwingkreis geeignet vorgegeben, bzw. begrenzt werden können.

Gemäß einer vorteilhaften Ausgestaltung des Erfindungsgedankens ist vorgesehen, dass das Referenzbauelement eine Luftspule ist. Die Induktivität einer Luftspule, die keinen magnetischen und insbesondere keinen weichmagnetischen Kern besitzt, kann durch vorab durchgeführte Messungen sehr präzise ermittelt werden. Darüber hinaus können nicht lineare Effekte bei einer Luftspule oftmals vernachlässigt werden. Zudem kann eine Luftspule mit geringem Aufwand effektiv gekühlt werden, sodass auch bei einem hohen Stromfluss keine unerwünschte Temperaturveränderung des Referenzbauelements und keine dadurch verursachte Beeinflussung der Messwerte befürchtet werden müssen.

Optional kann zusätzlich vorgesehen sein, dass mit einer Strommesseinrichtung ein Stromfluss durch das elektrische Bauelement messbar ist. Mit einer zusätzlichen Messung des Stromflusses durch das elektrische Bauelement können weitere charakteristische Eigenschaften des elektrischen Bauelements erfasst oder aus den zusätzlich gemessenen zeitabhängigen Messwerten für den Stromfluss ermittelt werden. Die Strommesseinrichtung kann beispielsweise eine torusförmige Luftspule sein, die um den stromführenden Leiter herum angeordnet ist. Eine derartige Messeinrichtung wird auch als Rogowski-Spule oder als Rogowski-Stromwandler bezeichnet. Es ist ebenfalls möglich, eine vergleichbare Spule mit einem Magnetkern zu verwenden, wobei eine derartige Spule auch als Pearson-Spule bezeichnet wird.

Der für die Anregung des Schwingkreises erforderliche Hochstromimpuls kann gemäß einer Ausgestaltung des Erfindungsgedankens in konstruktiv einfacher Weise dadurch erzeugt werden, dass die Messvorrichtung eine Steuereinrichtung und einen in dem Schwingkreis angeordneten Kondensator aufweist, wobei der Kondensator in einem ersten Steuerzustand der Steuereinrichtung über eine Ladeeinrichtung aufgeladen werden kann und wobei der Kondensator in einem zweiten Steuerzustand der Steuereinrichtung in dem Schwingkreis entladen wird und anschließend elektrische Schwingungen in dem Schwingkreis durchgeführt werden können. Mit der Steuereinrichtung muss in dem ersten Steuerzustand eine Entladung des Kondensators über den Schwingkreis verhindert werden, damit der Kondensator über die Ladeeinrichtung aufgeladen werden kann. Als Ladeeinrichtung kann ein Ladekondensator mit dem Schwingkreis und insbesondere mit dem Kondensator so verbunden werden, dass vorab in dem Ladekondensator gespeicherte elektrische Ladung auf den Kondensator übertragen werden kann, um diesen so aufzuladen, dass aus dem Kondensator ein Hochstromimpuls in den Schwingkreis abgegeben werden kann. Der Ladekondensator kann durch eine geeignete Ladeschaltung mit einer dafür vorgesehenen Spannungsquelle aufgeladen werden.

Vorzugsweise ist vorgesehen, dass die Steuereinrichtung einen in dem Schwingkreis angeordneten Thyristor aufweist, der durch die Steuereinrichtung eingeschaltet werden kann. Ein Thyristor kann in einfacher Weise durch die Steuereinrichtung so gesteuert werden, dass der Thyristor den Schwingkreis in dem ersten Steuerzustand der Steuereinrichtung sperrt und keinen Stromfluss in dem Schwingkreis zulässt und nach dem Einschalten des Thyristors den Schwingkreis freigibt und es dadurch ermöglicht, dass der Hochstromimpuls den elektrischen Schwingkreis anregt und anschließend die gedämpften elektrischen Schwingungen erfolgen können.

Um einen unerwünschten Einfluss der Steuereinrichtung auf den Schwingkreis zu reduzieren ist gemäß einer Ausgestaltung des Erfindungsgedankens vorgesehen, dass die Steuereinrichtung galvanisch von dem Schwingkreis getrennt ist.

Ein elektronisch lesbarer Datenträger kann eine darin gespeicherte Datenfolge enthalten, wobei die Datenfolge mindestens ein Messdatenpaket mit einer Hochstromimpulsinformation sowie mit zwei Messreihen eines zeitlichen Verlaufs eines Spannungsabfalls U(t) und eines Referenzspannungsabfalls $U_R$(t) für einen mit dem Hochstromimpuls angeregten elektrischen Schwingkreis mit einem elektrischen Bauteil und mit einem Referenzbauteil aufweist, der mit dem Hochstromimpuls zu einer gedämpften elektrischen Schwingung angeregt wurde. Die Datenfolge des mindestens einen Messdatenpakets ist vorzugsweise mit dem vorangehend beschriebenen Verfahren ermittelt worden. Optional kann für die Erfassung der Messdaten eine ebenfalls vorangehend beschrieben Messvorrichtung verwendet worden sein. Ausgehend von den Messdaten eines Messdatenpakets können zahlreiche verschiedene elektromagnetische Eigenschaften der jeweils untersuchten elektrischen Bauelemente bestimmt und berechnet werden. Die zur Verfügung stehenden Möglichkeiten zur nachträglichen Auswertung und Bestimmung von Eigenschaften der elektrischen Bauelemente gehen dabei weit über die Möglichkeiten hinaus, die bei herkömmlichen Messdatenpaketen zur Verfügung stehen. Auf diese Weise können weichmagnetische Materialien für die Verwendung in elektrischen Bauteilen kategorisiert und die entsprechenden elektrischen Bauteile standardisiert oder normiert werden. Darüber hinaus können die Messdatenpakete dazu verwendet werden, einen wesentlich aussagekräftigeren Vergleich der gemessenen Messdaten mit theoretischen Modellen zu elektromagnetischen Eigenschaften von elektrischen Bauelementen und insbesondere von elektrischen Bauelementen mit weichmagnetischen Materialien durchzuführen.

Optional ist vorgesehen, dass ein Messdatenpaket zusätzlich eine Messreihe eines zeitlichen Verlaufs eines Stromflusses durch das elektrische Bauteil aufweist.

Nachfolgend werden Ausführungsbeispiele des Erfindungsgedankens näher erläutert, die in der Zeichnung dargestellt sind. Es zeigt:

Figur 1 eine schematische Darstellung einer erfindungsgemäßen Messvorrichtung, die für die Durchführung des erfindungsgemäßen Messverfahrens geeignet ist,

Figur 2 eine detaillierte dargestellte Messvorrichtung,

Figur 3 eine schematische Darstellung des zeitlichen Verlaufs des gemessenen Spannungsabfalls U über dem elektrischen Bauelement, des gemessenen Referenzspannungsabfalls $U_R$ über dem Referenzbauelement und des gemessenen Stromflusses I während einer gedämpften Schwingung, die mit einem Hochstromimpuls in einem elektrischen Schwingkreis angeregt wurde, und

Figur 4 eine schematische Darstellung der für verschiedene Amplitudenmaxima des Stromflusses ermittelten Induktivität in Abhängigkeit von dem Stromfluss.

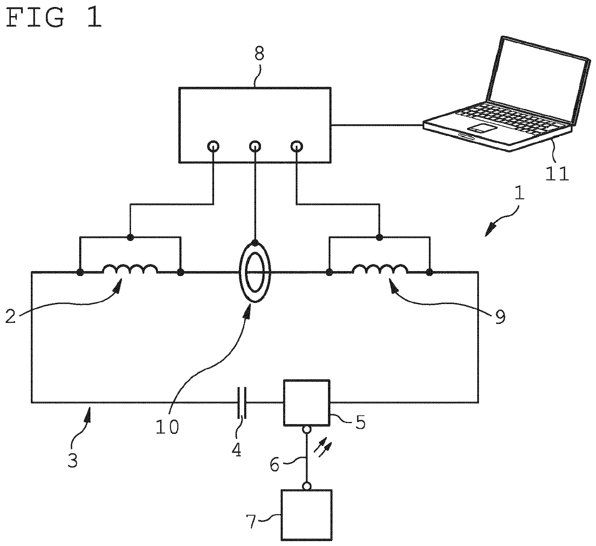

Eine in der Figur 1 schematisch dargestellte Messvorrichtung 1 zur Ermittlung der Induktivität L eines elektrischen Bauelements 2 weist einen elektrischen Schwingkreis 3 auf, in welchem zusätzlich zu dem elektrischen Bauelement 2 ein Kondensator 4 angeordnet ist.

Der Kondensator 4 kann mit einer geeigneten Ladevorrichtung 5 aufgeladen werden. Die Ladevorrichtung 5 ist über einen faseroptischen Lichtwellenleiter 6 mit einer Steuereinrichtung 7 verbunden. In einem ersten Steuerzustand der Steuereinrichtung 7 wird der Kondensator 4 mit der Ladevorrichtung 5 aufgeladen. Wenn die Steuereinrichtung 7 in einen zweiten Steuerzustand wechselt, wird der elektrische Schwingkreis 3 freigegeben und durch die plötzliche Entladung des zuvor aufgeladenen Kondensators 4 ein Hochstromimpuls in dem elektrischen Schwingkreis erzeugt, der eine gedämpfte elektrische Schwingung in dem elektrischen Schwingkreis 3 anregt.

Während der abklingenden elektrischen Schwingung in dem elektrischen Schwingkreis 3 wird mit Hilfe eines Digitaloszilloskops 8 ein Spannungsabfall U(t) über dem elektrischen Bauelement 2 gemessen, dessen Induktivität L ermittelt werden soll.

In dem elektrischen Schwingkreis 3 ist zusätzlich zu dem elektrischen Bauelement 2 ein Referenzbauelement 9 angeordnet. Das Referenzbauelement 9 weist ebenfalls eine Induktivität $L_R$ auf, die durch geeignete Messungen vorab ermittelt wurde. Mit dem Digitaloszilloskop 8 kann über einen weiteren Messkanal ein Spannungsabfall $U_R$(t) über das Referenzbauelement gemessen werden. Wenn ein ohmscher Widerstand R in dem elektrischen Schwingkreis 3, bzw. insbesondere in dem elektrischen Bauelement 2 vernachlässigt werden kann, kann die gesuchte Induktivität L des elektrischen Bauelements 2 näherungsweise als Produkt der bekannten Induktivität $L_R$ des Referenzbauelements 9 und dem Quotienten der gemessenen Spannungsabfälle U(t)/$U_R$(t) berechnet werden:

$$L = L_R \, \frac{U(t)}{U_R(t)}$$

In dem elektrischen Schwingkreis 3 ist neben dem elektrischen Bauelement 2 eine beispielsweise als Rogowski-Spule oder als Pearson-Spule ausgestaltete Strommessvorrichtung 10 angeordnet, deren Messwerte ebenfalls mit dem Digitaloszilloskop 8 erfasst und ausgewertet werden können. Mit der Strommessvorrichtung 10 wird während der elektrischen Schwingungen in dem elektrischen Schwingkreis 3 ein Stromfluss I(t) durch das elektrische Bauelement 2 gemessen. An den Extrempunkten der aufeinander folgenden Amplitudenmaxima $I_{peak}$ des zeitlich sich verändernden Stromflusses I(t) während der elektrischen Schwingungen kann der ohmsche Widerstand R des elektrischen Bauelements 2 als Quotient aus dem Spannungsabfall U (t=t ($I_{peak}$)) an einem Extrempunkt $I_{peak}$ und dem Stromfluss I (t=t ($I_{peak}$)) an dem Extrempunkt berechnet werden. Durch eine Mittelwertbildung für mehrere aufeinanderfolgende Extrempunkte, bzw. Amplitudenmaxima des Stromflusses kann der daraus ermittelte ohmsche Widerstand R weiter präzisiert werden.

Eine Auswertung der über die Messdauer hinweg gemessenen Messwerte für die beiden Spannungsabfälle U(t) und $U_R$(t) sowie gegebenenfalls für den Stromfluss I(t) kann mit einer geeigneten Datenverarbeitungsanlage 11 bzw. einer darauf ausgeführten Auswertesoftware durchgeführt werden. Dabei kann die gesuchte Induktivität L des elektrischen Bauelements 2 als Produkt der bekannten Induktivität $L_R$ des Referenzbauelements 9 und einem Proportionalitätsfaktor ermittelt werden, wobei der Proportionalitätsfaktor der Quotient aus einerseits der Differenz zwischen dem gemessenen Spannungsabfalls U über dem elektrischen Bauelement 2 und dem Spannungsabfall R I über dem ohmschen Widerstand des elektrischen Bauelements 2 und andererseits dem gemessenen Spannungsabfall $U_R$ über dem Referenzbauelement 9 ergibt. Die Berechnung kann durch die nachfolgend wiedergegebene Formel zusammengefasst werden:

$$L(I) = L_R \frac{(U(t) - R\,I(t))}{U_R(t)}$$

Die Induktivität L des elektrischen Bauelements 2 ist dabei im Wesentlichen von dem jeweiligen Stromfluss I abhängig. Zudem ist die Induktivität insbesondere bei elektrischen Bauelementen mit weichmagnetischen Materialien wegen des nicht-linearen Sättigungsverhaltens auch von dem jeweiligen Hochstromimpuls bzw. von einem unmittelbar vorher durch das elektrische Bauelement bewirkten Stromfluss abhängig.

Wenn das elektrische Bauelement 2 eine induktive Komponente mit einem weichmagnetischen Material aufweist, ist es zweckmäßig, dass der elektrische Schwingkreis 3 mit einem Hochstromimpuls von mehreren kA zu elektrischen Schwingungen angeregt wird.

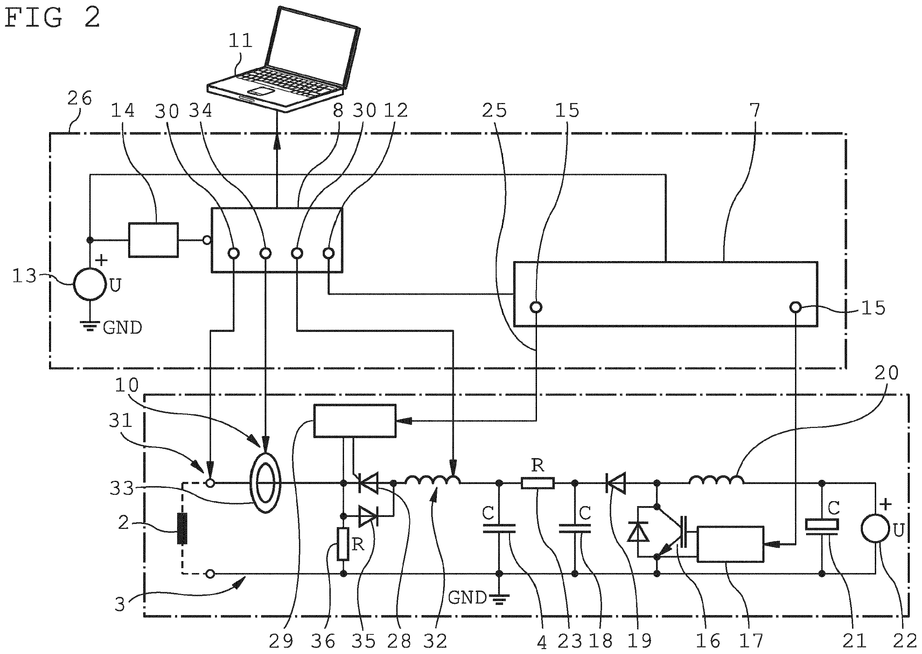

Anhand einer in Figur 2 etwas detaillierter abgebildeten Messvorrichtung 1 wird eine Durchführung einer Messung zur Ermittlung der Induktivität L des elektrischen Bauelements 2 erläutert. Mittels einer geeigneten Software erhält das Digitaloszilloskop 8 über eine Schnittstelle von der Datenverarbeitungsanlage 11 einen Befehl zur Erzeugung eines elektrischen Steuersignals an einen seiner Waveform-Ausgänge 12. Dieses Steuersignal wird weitergegeben an die Steuereinrichtung 7 zur Hochstromimpulserzeugung. Sowohl das Digitaloszilloskop 8 als auch die Steuereinrichtung 7 sind über geeignete Anschlüsse mit einer Spannungsquelle 13 verbunden. Ein DC/DC-Konverter 14 wandelt eine Ausgangsspannung von der Spannungsquelle 13 in eine für das Digitaloszilloskop 8 geeignete Eingangsspannung um. In Abhängigkeit von der Dauer des Steuersignals wird mit Hilfe einer mit der Steuereinrichtung 7 erzeugten Pulswellenmodulation über einen fiberoptischen Ausgang 15 ein Hochstellsetzer bzw. ein Step-Up-Konverter (16, 17, 18, 19, 20, 21, 22) angesteuert, der über einen Ladewiderstand 23 den Kondensator 4 auf eine für den Hochstromimpuls geeignete Spannung auflädt.

Der Hochstellsetzer weist vorzugsweise einen IGBT 16, eine fiberoptischen Optokoppler 17, einem Ladekondensator 18, eine Diode 19, ein induktives Bauelement 20, einen Kondensator 21 und eine geeignete Spannungsversorgung 22 auf. Fiberoptische Signalleitungen 24 und 25 gewährleisten eine galvanisch getrennte Verbindung zwischen einem Steuer- und Auswertekreis 26 und einem Impuls- und Messkreis 27 und minimieren den Einfluss elektromagnetischer Störsignale, die im Impuls- und Messkreis 27 auftreten können. Aus Gründen der Betriebssicherheit kann ein gemeinsames Bezugspotential bzw. eine gemeinsame Erdung vorgesehen werden.

Sobald das Steuersignal des Digitaloszilloskops 8 beendet wird, geht das Steuersignal in eine negative Flanke über. Diese negative Flanke deaktiviert die Pulswellenmodulation für den Hochstellsetzer und aktiviert eine in der Steuereinrichtung 7 hinterlegte zeitliche Sequenz, die über die galvanisch getrennte fiberoptische Signalleitung 25 einen Hochstromthyristor 28 aktiviert. Der Steuerstrom für einen Thyristor 28 wird über eine fiberoptische Signalverarbeitungseinrichtung 29 erzeugt. Anstelle eines Hochstromthyristors 28 kann auch eine andere geeignete Steuerschaltung verwendet werden, die beispielsweise einen Bipolartransistor mit einer isolierten Gate-Elektrode (IGBT) oder einen Metall-Oxid-Halbleiter-Feldeffekttransistor (MOSFET) aufweist.

Dadurch wird in dem elektrischen Schwingkreis 3 ein Hochstromimpuls erzeugt und eine elektrische Schwingung angeregt. Der elektrische Schwingkreis umfasst den Kondensator 4, das Referenzbauelement 9 und das zu messende elektrische Bauelement 2. Sowohl die maximal auftretende Spitzenamplitude des Stromflusses bei dem Hochstromimpuls als auch die Änderungsrate des Stromflusses dI(t)/dt können durch eine geeignete Dimensionierung des Referenzbauelements 9 vorgegeben und insbesondere begrenzt werden.

Über Analogeingänge 30 des Digitaloszilloskops 8 werden mit Hilfe von geeigneten Spannungsmesseinrichtungen 31, 32 der Spannungsabfall U über dem elektrischen Bauelement 2 und der Spannungsabfall $U_R$ über dem Referenzbauelement erfasst. Mit Hilfe einer geeigneten Strommesseinrichtung 10, die beispielsweise eine Pearson-Spule 33 aufweist, wird über einen weiteren Analogeingang 34 des Digitaloszilloskops 8 der Stromfluss I(t) durch das elektrische Bauelement erfasst.

Da in den meisten Fällen der resultierende Resonanzkreis unterkritisch gedämpft ist, ermöglicht eine Freilaufdiode 35 eine Stromumkehr und somit eine bipolare Aussteuerung des elektrischen Bauelements, was für zahlreiche Anwendungen wie beispielsweise für das Erfassen des Sättigungsverhaltens des elektrischen Bauelements von Vorteil ist.

Der Kondensator 4 kann durch eine Aktivierung des Thyristors 28 über einen geeigneten Widerstand 36 entladen werden. Der Widerstand 36 sollte dabei so bemessen sein, dass seine Impedanz relativ groß ist im Vergleich zu dem elektrischen Bauelement 2.

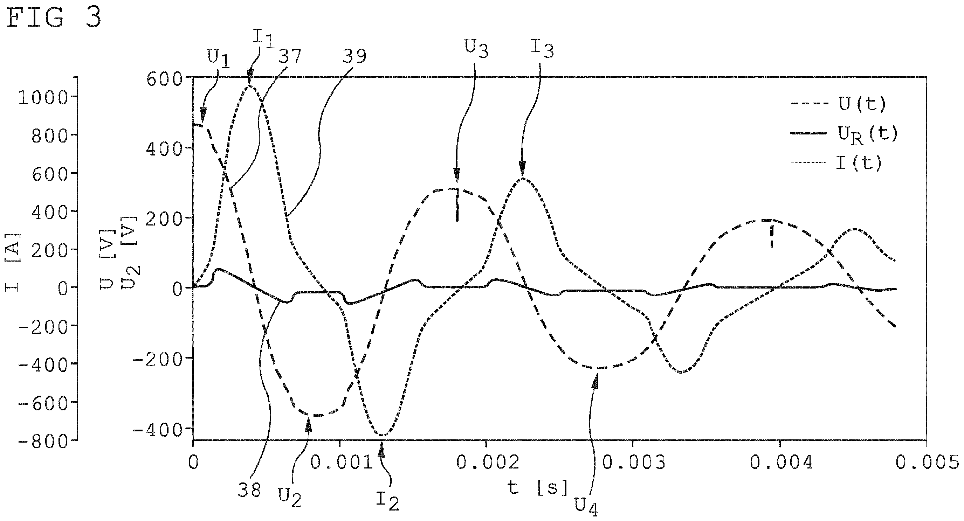

In Figur 3 sind exemplarisch über mehrere Schwingungen des elektrischen Schwingkreises 3 hinweg der zeitliche Verlauf der über dem elektrischen Bauelement 2 abfallenden Spannung U(t) 37, der über dem Referenzbauelement 9 abfallenden Referenzspannung

$U_R(t)$ 38 und der durch das elektrische Bauelement 2 hindurch fließenden Stromflusses $I(t)$ 39 dargestellt. Mit geeigneten mathematischen Methoden können die aufeinanderfolgenden Extremstellen $U_1$, $U_2$, $U_3$ etc. und $I_1$, $I_2$, $I_3$ etc. der einzelnen zeitlichen Verläufe ermittelt werden. An den Extremstellen des Stromflusses kann jeweils der ohmsche Widerstand R des elektrischen Bauteils 2 ermittelt und über mehrere Extremstellen hinweg gemittelt werden. Ausgehend von jeweils zwei aufeinanderfolgenden Extremwerten $U_1$, $U_2$, $U_3$ etc. für den Spannungsabfall $U(t)$ kann die Einfügedämpfung $a_I(I_{Puls})$ ermittelt werden, wobei die Einfügedämpfung $a_I(I_{Puls})$ abhängig ist von dem Extremwert des maximalen Stromflusses ist, von welchem ausgehend die Einfügedämpfung $a_I(I_{Puls})$ ermittelt wird.

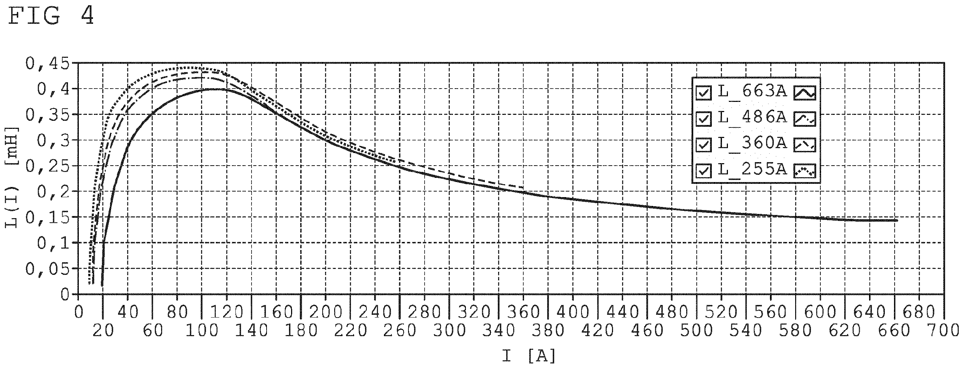

Für jede Halbwelle nach einer Extremstelle des Stromflusses $I_1$, $I_2$, $I_3$ etc. kann die von dem zeitlich sich verändernden Verlauf des Stromflusses $I(t)$ abhängige Induktivität $L(I_{puls} = I_1, I_2, I_3$ etc.) ermittelt werden. Für mehrere aufeinanderfolgende Extremstellen des in Figur 3 dargestellten zeitlichen Verlaufs der gedämpften Schwingung in dem elektrischen Schwingkreis 3 ist die jeweilige Induktivität $L(I)$ als Funktion der Stromstärke in Figur 4 schematisch dargestellt. Die Induktivität $L(I)$ ist dabei für eine vorgegebene Stromstärke I insbesondere bei einem vergleichsweise niedrigen Stromfluss von bis zu 150 A nicht gleich, sondern deutlich abhängig von dem Maximalwert des Stromflusses an der vorausgegangenen Extremstelle $I_1$, $I_2$, $I_3$ etc. des während der gedämpften Schwingung durch das elektrische Bauteil 2 fließenden Stroms. Mit diesen Informationen über das Sättigungsverhalten des elektrischen Bauteils 2 und die Induktivität bzw. die Energieverluste EL des elektrischen Bauteils 2 während eines Stromflusses können neue elektrische Bauteile so ausgelegt werden, dass sie für den jeweiligen Verwendungszweck insbesondere in der Leistungselektronik bestmöglich angepasst sind.

## Patentansprüche

1. Verfahren zur Ermittlung der Induktivität L eines elektrischen Bauelements (2), wobei in einem Anregungsschritt mindestens ein Hochstromimpuls erzeugt und durch das elektrische Bauelement (2) geführt wird, wobei in einem Messschritt über eine Messdauer hinweg elektrische Eigenschaften des elektrischen Bauelements (2) gemessen werden, wobei in einem Auswerteschritt aus den gemessenen elektrischen Eigenschaften die Induktivität L des elektrischen Bauelements (2) ermittelt wird, wobei in dem Messschritt ein Spannungsabfall U über das elektrische Bauelement (2) sowie ein Referenzspannungsabfall $U_R$ über ein mit dem elektrischen Bauelement (2) in Reihe geschaltetes Referenzbauelement (9) mit einer bekannten Referenzinduktivität $L_R$ gemessen wird, und wobei in dem Auswerteschritt die Induktivität L des elektrischen Bauelements (2) als Produkt der Referenzinduktivität $L_R$ mit einem Proportionalitätsfaktor berechnet wird, der von dem gemessenen Spannungsabfall U und dem gemessenen Referenzspannungsabfall $U_R$ abhängt.

2. Verfahren nach Anspruch 1, **dadurch gekennzeichnet, dass** während des Messschritts auch ein Stromfluss I durch das elektrische Bauelement (2) gemessen wird.

3. Verfahren nach Anspruch 2, **dadurch gekennzeichnet, dass** in dem Auswerteschritt der Proportionalitätsfaktor als Quotient von einerseits der Differenz zwischen dem gemessenen Spannungsabfall U und dem Produkt des ohmschen Widerstands R des elektrischen Bauelements (2) und dem gemessenen Stromfluss I und andererseits des gemessenen Referenzspannungsabfalls $U_R$ berechnet wird.

4. Verfahren nach Anspruch 3, **dadurch gekennzeichnet, dass** der ohmsche Widerstand als Mittelwert der Quotienten aus dem Spannungsabfall U und dem Stromfluss I an mehreren Amplitudenmaxima des Stromflusses I durch das elektrische Bauelement (2) während des Messschritts ermittelt wird.

5. Verfahren nach einem der vorangehenden Ansprüche 1 bis 4, **dadurch gekennzeichnet, dass** während des Anregungsschritts der Hochstromimpuls mit einer Steuereinrichtung (7) ausgelöst wird, die galvanisch von dem Stromkreislauf mit dem elektrischen Bauelement (2) getrennt ist.

6. Verfahren nach einem der vorangehenden Ansprüche 1 bis 5, **dadurch gekennzeichnet, dass** ein Energieverlust als ein über eine Halbwelle zwischen zwei aufeinanderfolgenden Amplitudenmaxima $U_1$ und $U_2$ des Spannungsabfalls über dem elektrischen Bauteil integrierten Produkt des Spannungs- und Stromverlaufs ermittelt wird.

7. Messvorrichtung (1) zur Ermittlung der Induktivität eines elektrischen Bauelements (2), wobei das elektrische Bauelement (2) in einem Schwingkreis (3) angeordnet ist, wobei die Messvorrichtung eine mit dem Schwingkreis (3) verbundene Stromquelle aufweist, mit welcher ein Hochstromimpuls in dem Schwingkreis (3) erzeugt werden kann, wobei mit einer Spannungsmessvorrichtung (31) ein Spannungsabfall U über das elektrische Bauelement (2) messbar ist, wobei ein Referenzbauelement (9) mit einer Referenzinduktivität $L_R$ in Reihe mit dem elektrischen Bauelement (2) in dem Schwingkreis (3) angeordnet ist, wobei mit einer Referenzspannungsmessvorrichtung (32) ein Referenzspannungsabfall $U_R$ über das Referenzbauelement (9) messbar ist, und wobei die Messvorrichtung (1) dazu eingerichtet ist, die Induktivität L des elektrischen Bauelements (2) als Produkt der Referenzinduktivität $L_R$ mit einem Proportionalitätsfaktor zu berechnen, der von dem gemessenen Spannungsabfall U und dem gemessenen Referenzspannungsabfall $U_R$ abhängt.

**8.** Messvorrichtung (1) nach Anspruch 7, **dadurch gekennzeichnet, dass** das Referenzbauelement (9) eine Luftspule ist.

**9.** Messvorrichtung (1) nach Anspruch 7 oder Anspruch 8, **dadurch gekennzeichnet, dass** mit einer Strommesseinrichtung (33) ein Stromfluss durch das elektrische Bauelement (2) messbar ist.

**10.** Messvorrichtung (1) nach einem der Ansprüche 7 bis 9, **dadurch gekennzeichnet, dass** die Messvorrichtung (1) eine Steuereinrichtung (7) und einen in dem Schwingkreis (3) angeordneten Kondensator (4) aufweist, wobei die Messvorrichtung (1) so eingerichtet ist, dass der Kondensator (4) in einem ersten Steuerzustand der Steuereinrichtung (7) über eine Ladeeinrichtung (5) aufgeladen werden kann und wobei der Kondensator (4) in einem zweiten Steuerzustand der Steuereinrichtung (7) in dem Schwingkreis (3) entladen wird und anschließend elektrische Schwingungen in dem Schwingkreis (3) durchgeführt werden können.

**11.** Messvorrichtung (1) nach einem der Ansprüche 7 bis 10, **dadurch gekennzeichnet, dass** die Steuereinrichtung (7) einen in dem Schwingkreis (3) angeordneten Thyristor (28) aufweist, der durch die Steuereinrichtung (7) eingeschaltet werden kann.

**12.** Messvorrichtung (1) nach einem der Ansprüche 7 bis 11, **dadurch gekennzeichnet, dass** die Steuereinrichtung (7) galvanisch von dem Schwingkreis (3) getrennt ist.

**Claims**

**1.** Method for determining the inductance L of an electrical component (2), wherein a high-current pulse is generated in an excitation step and is guided through the electrical component (2), wherein in a measuring step, electrical properties of the electrical component (2) are measured over a measurement period, wherein in an evaluation step, the inductance L of the electrical component (2) is determined from the measured electrical properties, wherein in the measuring step a voltage drop U across the electrical component (2) and a reference voltage drop $U_R$ across the reference component (9), which has a known reference inductance $L_R$ and is connected in series with the electrical component (2), are measured, and wherein in the evaluation step, the inductance L of the electrical component (2) is calculated as the product of the reference inductance $L_R$ with a proportionality factor that is dependent on the measured voltage drop U and the measured reference voltage drop $U_R$.

**2.** Method according to claim 1, **characterised in that**, during the measuring step, a current flow I through the electrical component (2) is also measured.

**3.** Method according to claim 2, **characterised in that** in the evaluation step, the proportionality factor is calculated as a quotient of, on the one hand, the difference between the measured voltage drop U and the product of the ohmic resistance R of the electrical component (2) and the measured current flow I and, one the other hand, the measured reference voltage drop $U_R$.

**4.** Method according to claim 3. **characterised in that** the ohmic resistance is determined as the average of the quotients of the voltage drop U and the current flow I at a plurality of amplitude maxima of the current flow I through the electrical component (2) during the measuring step.

**5.** Method according to any one of claims 1 to 4, **characterised in that**, during the excitation step, the high current pulse is triggered by a controller (7), which is galvanically isolated from a circuit having the electrical component (2).

**6.** Method according to any one of the preceding claims 1 to 5, **characterised in that** an energy loss is determined as a product of the voltage and current progression, integrated over a half-wave between two successive amplitude maxima $U_1$ and $U_2$ of the voltage drop across the electrical component.

**7.** Measuring device (1) for determining the inductance of an electrical component (2), wherein the electrical component (2) is arranged in a resonant circuit (3), wherein the measuring device has a current source that can be connected to the resonant circuit (3) and by means of which a high current pulse in the resonant circuit (3) can be generated, wherein a voltage drop U across the electrical component (2) can be measured using a voltmeter (31), wherein a reference component (9) having a reference inductance $L_R$ is arranged in series with the electrical component (2), in the resonant circuit (3), wherein a reference voltage drop $U_R$ across the reference component (9) can be measured using a reference voltmeter (32), and wherein the measuring device (1) is configured to calculate the inductance L of the electrical component (2) as the product of the reference inductance $L_R$ with a proportionality factor that depends on the measured voltage drop U and the measured reference voltage drop $U_R$.

8. Measuring device (1) according to claim 7, **characterised in that** the reference component (9) is an air coil.

9. Measuring device (1) according to claim 7 or claim 8, **characterised in that** a current flow through the electrical component (2) can be measured by an ammeter (33).

10. Measuring device (1) according to any one of claims 7 to 9 **characterised in that** the measuring device (1) has a controller (7) and a capacitor (4) arranged in the resonant circuit (3), wherein the measuring device (1) is configured such that the capacitor (4) can be charged via a charging device (5) in a first control state of the controller (7) and wherein the capacitor (4) is discharged in the resonant circuit (3) in a second control state of the controller (7), and subsequently electrical oscillations are performed in the resonant circuit (3).

11. Measuring device (1) according to any one of claims 7 to 10, **characterised in that** the controller (7) has a thyristor (28) arranged in the resonant circuit (3) and can be activated by the controller (7).

12. Measuring device (1) according to any one of claims 7 to 11, **characterised in that** the controller (7) is galvanically isolated from the resonant circuit (3).

**Revendications**

1. Procédé de détermination de l'inductance L d'un composant électrique (2), dans lequel au moins une impulsion de courant fort est générée dans une étape d'excitation et est guidée à travers le composant électrique (2), dans lequel des propriétés électriques du composant électrique (2) sont mesurées sur une période de mesure dans une étape de mesure, dans lequel l'inductance L du composant électrique (2) est déterminée à partir des propriétés électriques mesurées dans une étape d'interprétation, dans lequel une chute de tension U sur le composant électrique (2) ainsi qu'une chute de tension de référence $U_R$ sur un composant de référence (9) branché en série avec le composant électrique (2) sont mesurées avec une inductance de référence $L_R$ connue dans l'étape de mesure, et dans lequel l'inductance L du composant électrique (2) est calculée dans l'étape d'interprétation en tant que produit de l'inductance de référence $L_R$ avec un facteur de proportionnalité, qui dépend de la chute de tension U mesurée et de la chute de tension de référence $U_R$ mesurée.

2. Procédé selon la revendication 1, **caractérisé en ce qu'**un flux de courant I à travers le composant électrique (2) est également mesuré pendant l'étape de mesure.

3. Procédé selon la revendication 2, **caractérisé en ce que** le facteur de proportionnalité est calculé, dans l'étape d'interprétation, en tant que quotient d'une part de la différence entre la chute de tension U mesurée et le produit de la résistance ohmique R du composant électrique (2) et le flux de courant I mesuré et d'autre part de la chute de tension de référence $U_R$ mesurée.

4. Procédé selon la revendication 3, **caractérisé en ce que** la résistance ohmique est déterminée en tant que moyenne du quotient de la chute de tension U et du flux de courant I sur plusieurs maxima d'amplitude du flux de courant I à travers le composant électrique (2) pendant l'étape de mesure.

5. Procédé selon l'une quelconque des revendications précédentes 1 à 4, **caractérisé en ce que** l'impulsion de courant fort est déclenchée, pendant l'étape d'excitation, par un système de commande (7), qui est séparé de manière galvanique du circuit de courant avec le composant électrique (2) .

6. Procédé selon l'une quelconque des revendications précédentes 1 à 5, **caractérisé en ce qu'**une perte d'énergie est déterminée en tant qu'un produit de la variation de tension et de courant intégré sur une demi-onde entre deux maxima d'amplitude $U_1$ et $U_2$ se suivant l'une l'autre de la chute de tension sur le composant électrique.

7. Dispositif de mesure (1) pour déterminer l'inductance d'un composant électrique (2), dans lequel le composant électrique (2) est disposé dans un circuit oscillant (3), dans lequel le dispositif de mesure présente une source de courant reliée au circuit oscillant (3), avec laquelle une impulsion de courant fort peut être générée dans le circuit oscillant (3), dans lequel une chute de tension U sur le composant électrique (2) peut être mesurée avec un dispositif de mesure de tension (31), dans lequel un composant de référence (9) avec une inductance de référence $L_R$ est disposé dans le circuit oscillant (3) en série avec le composant électrique (2), dans lequel une chute de tension de référence $U_R$ peut être mesurée sur le composant de référence (9) avec un dispositif de mesure de tension de référence (32), et dans lequel le dispositif de mesure (1) est mis au point pour calculer l'inductance L du composant électrique (2) en tant que produit de l'inductance de référence $L_R$ avec un facteur de proportionnalité, qui dépend de la chute de tension U mesurée et de la chute de tension de référence $U_R$ mesurée.

8. Dispositif de mesure (1) selon la revendication 7, **caractérisé en ce que** le composant de référence (9) est une bobine à air.

9. Dispositif de mesure (1) selon la revendication 7 ou la revendication 8, **caractérisé en ce qu'**un flux de courant à travers le composant électrique (2) peut être mesuré avec un système de mesure de courant (33).

10. Dispositif de mesure (1) selon l'une quelconque des revendications 7 à 9, **caractérisé en ce que** le dispositif de mesure (1) présente un système de commande (7) et un condensateur (4) disposé dans le circuit oscillant (3), dans lequel le dispositif de mesure (1) est mis au point de telle sorte que le condensateur (4) peut être rechargé par l'intermédiaire d'un système de charge (5) dans un premier état de commande du système de commande (7) et dans lequel le condensateur (4) est déchargé dans le circuit oscillant (3) dans un deuxième état de commande du système de commande (7) puis des oscillations électriques peuvent être mises en œuvre dans le circuit oscillant (3).

11. Dispositif de mesure (1) selon l'une quelconque des revendications 7 à 10, **caractérisé en ce que** le système de commande (7) présente un thyristor (28) disposé dans le circuit oscillant (3), qui peut être activé par le système de commande (7).

12. Dispositif de mesure (1) selon l'une quelconque des revendications 7 à 11, **caractérisé en ce que** le système de commande (7) est séparé de manière galvanique du circuit oscillant (3).

FIG 1

FIG 2

FIG 3

FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 2944472 A1